# EUROPEAN PATENT APPLICATION

(11) **EP 2 166 409 A2**
(43) Date of publication of application: **24.03.2010**
(21) Application number: 09155930.2
(22) Date of filing: 23.03.2009
(51) Int. Cl.: G03F 7/00, G03F 7/033

(54) **Alkaline developable super-hydrophobic photosensitive materials**

(30) Priority: 22.09.2008 KR 20080092556
(71) Applicant: Rohm and Haas Electronic Materials Korea Ltd., Chonan, Chungnam 330-220 (KR)
(72) Inventor: Park, Chun Geun, Seoul (KR); Lee, Moo Young, Chungnam 330-220 (KR); Han, Seok, 140-190 Seoul (KR); Kim, Seung Keun, 140-131 Seoul (KR); Sung, In Kyung, 361-749 Chungbuk (KR); Lee, Hag Ju, 330-210 Chungcheongnam-do (KR)
(74) Representative: Kent, Venetia Katherine

(57) **Abstract**

Disclosed is a super-hydrophobic photosensitive resin composition suitable for forming barrier ribs for LCD pixels during a process for fabricating an LCD using an ink jet printing step. Also, disclosed is a transparent negative photosensitive developable super-hydrophobic material for ink jet printing, which has super-hydrophobicity characterized by a contact angle value of > 90° to distilled water and a contact angle value of > 35° to ethyl cellosolve, is sufficiently dissolved into a developing agent before and after exposure, and can realize a micropattern with a size up to 10 µm. A photosensitive resin composition comprising a resin part and a multi-functional (meth)acrylate is subjected to UV curing using a photoinitiator and thermal curing to form the barrier ribs for LCD pixels, wherein the resin part comprises a copolymer system containing a C₄-C₃₀ saturated or unsaturated fluoro-substituted hydrocarbyl group and saturated or unsaturated hydrocarbyl group introduced thereto to provide super-hydrophobicity, a unit functioning as a reactive site and having a reactive group such as an epoxy group, methacrylate group or acrylate group as a moiety that undergoes a reaction under heat or light, and a unit having a carboxylic acid group so as to allow post-exposure development.

## Description

### CROSS-REFERENCE TO RELATED APPLICATION

This application claims priority under 35 U.S.C. §119 the benefit of Korean Patent Application No. 10-2008-0092556, filed September 22, 2008, the entire contents of which are incorporated herein by reference.

### BACKGROUND

### Technical Field

The present invention relates to a process for fabricating an LCD comprising an ink jet printing step.

Particularly, the present invention relates to a super-hydrophobic photosensitive resin composition suitable for forming barrier ribs for defining LCD pixels during the fabrication of an LCD using an ink jet printing step.

More particularly, the present invention provides a super-hydrophobic photosensitive resin composition, which is used to produce super-hydrophobic barrier ribs for LCD pixels, and realizes sufficient adhesion and high diffusibility of inks when an ink jet printing step is performed by using RGB (red, green and blue) inks (i.e., when the RGB inks are sprayed or dropped into developed cells by way of ink jet printing) after the formation of the barrier ribs for LCD pixels. In addition, the barrier ribs (i.e. pattern for forming the pixels) formed from the composition ensures such an extreme degree of hydrophobicity that the inks maintain their droplets in a cell without overflowing toward another cell in spite of an excessive dropping amount.

### Description of the Related Art

In a process for fabricating an LCD, an ink jet printing step has been recently spotlighted as an advanced technological step that enables thinning of an LCD device and improves the productivity thereof, because the ink jet printing step allows skipping of two photolithographic steps and steps of patterning each color photoresist (PR) for RGB, thereby simplifying the overall process.

However, to carry out the ink jet printing step successfully, RGB inks should have sufficient adhesion and high wetting ability when they are sprayed or dropped into the developed cells (pixels). Additionally, the barrier ribs (i.e., pattern for forming the pixels) have to ensure such an extreme degree of hydrophobicity that the inks maintain their droplets in a cell without overflowing toward another cell in spite of an excessive dropping amount.

In a current method for satisfying the both extremes of characteristics, it is known that a patterning step is carried out first by using a general passivation material for organic insulator, followed by post-treatment steps such as ashing and plasma treatment.

However, such post-treatment steps cause problems in that cost of equipment investment increases markedly and the productivity decreases significantly. Moreover, it has been recently found that such post-treatment steps are not practically applicable, since they may cause a non-uniform plasma concentration as LCD panels become large-sized.

The above information disclosed in this Background section is only for enhancement of understanding of the background of the invention and therefore it may contain information that does not form the prior art that is already known in this country to a person of ordinary skill in the art.

### SUMMARY OF THE DISCLOSURE

The present invention has been made in an effort to solve the above-described problems associated with the prior art.

It is an object of the present invention to provide a transparent negative photosensitive super-hydrophobic material for ink jet printing, which has super-hydrophobicity characterized by a contact angle value of > 90° to distilled water and a contact angle value of > 35° to ethyl cellosolve, is sufficiently dissolved in a developing agent before and after exposure, and can realize a micropattern with a size up to 15 µm, preferably up to 10 µm.

The inventors of the present invention have conducted many studies to provide the above-described super-hydrophobic material for forming barrier ribs for pixels of an LCD, and have developed a transparent material for barrier ribs that has not only super-hydrophobicity but also sufficient post-exposure solubility, thereby forming a micropattern with a size up to 10 µm.

Other aspects, features and preferred embodiments of the invention are discussed infra.

### BRIEF DESCRIPTION OF THE DRAWINGS

The above and other features of the present invention will now be described in detail with reference to certain example embodiments thereof illustrated in the accompanying drawings which are given hereinbelow by way of illustration only, and thus are not limitative of the present invention, and wherein:
FIG. 1 is a schematic view illustrating the polymer chain reconstruction and photocuring steps;
FIG. 2 is a schematic view illustrating the photocuring and thermal curing steps in the presence of thermally curable functional groups;
FIG. 3 is a photographic view of the barrier ribs produced according to Examples 1-5 taken by SEM (scanning electron microscopy) after the exposure, development and Hard baking;
FIG. 4 is a photographic view of the barrier ribs produced according to Examples 6-10 taken by SEM after the exposure ,development and Hard baking ; and
FIG. 5 is a photographic view of the barrier ribs produced according to Comparative Examples 1-3 taken by SEM after the exposure, development and hard baking.

It should be understood that the appended drawings are not necessarily to scale, presenting a somewhat simplified representation of various preferred features illustrative of the basic principles of the invention. The specific design features of the present invention as disclosed herein, including, for example, specific dimensions, orientations, locations and shapes will be determined in part by the particular intended application and use environment.

In the figures, reference numerals refer to the same or equivalent parts of the present invention throughout the figures of the drawing.

### DETAILED DESCRIPTION OF THE INVENTION

Hereinafter, reference will now be made in detail to various embodiments of the present invention, examples of which are illustrated in the accompanying drawings and described below. While the invention will be described in conjunction with example embodiments, it will be understood that the present description is not intended to limit the invention to those example embodiments. On the contrary, the invention is intended to cover not only the example embodiments, but also various alternatives, modifications, equivalents and other embodiments, which may be included within the spirit and scope of the invention as defined in the appended claims.

In one aspect, the present invention provides a super-hydrophobic photosensitive resin composition for forming barrier ribs for LCD pixels by diluting 100 parts by weight of a photosensitive resin composition with 50-1,000 parts by weight of a solvent, and coating the photosensitive resin composition onto a glass substrate, followed by patterning and developing, wherein the photosensitive resin composition comprises:
(A) 100 parts by weight of a first polymer prepared by polymerizing ingredients including (a1) 10-70 wt% of a radical reactive monomer having a C₄-C₃₀ cyclic or acyclic saturated or unsaturated alkyl, aryl, aralkyl or alkylaryl substituent, (a2) 3-40 wt% of at least one monomer selected from (meth)acrylic acid, vinyl alcohol and vinyl thiol, (a3) 5-40 wt% of (meth)acrylate end-capped with (meth)acryl group or 3-acryloyloxy-2-hydroxypropyl group, and (a4) 5-30 wt% of a radical reactive monomer having a fluoro-substituted C₄-C₃₀ cyclic or acyclic saturated or unsaturated alkyl, aryl, aralkyl or alkylaryl substituent;
(B) 50-120 parts by weight of a multi-functional (meth)acrylate monomer; and
(C) 1-20 parts by weight of a photo initiator.

A particular example of ingredient (A) includes a polymer represented by the following Formula 1. Each unit forming the first polymer is preferably used in the above weight ratio. This is because when each unit forming the first polymer is used in an amount away from the above range, the material cannot realize sufficient hydrophobicity or may be re-absorbed onto the resultant pattern after development. Particularly, when ingredient (a3) is used in an amount lower than the above range, the resultant polymer shows an excessively lowered crosslinking density, resulting in a problem related to a severe film thickness loss. On the other hand, when ingredient (a3) is used in an amount higher than the above range, it may cause storage stability or other problems including scum generation. Although there is no particular limitation in the molecular weight of the first polymer, the first polymer preferably has a number average molecular weight of 500-100,000, and more preferably of 1,000-50,000. 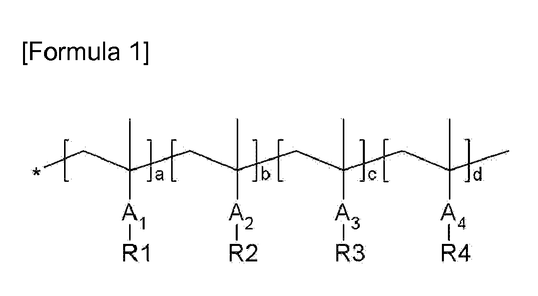
wherein A₁, A₂, A₃ and A₄ each represent -O-, -OCO-, -COO-, -S-, -CONH-, - NHCO-, or a covalent bond;
R1 independently represents at least one selected from C₄-C₃₀ saturated or unsaturated alkyl groups, saturated or unsaturated aralkyl groups, saturated or unsaturated alkylaryl groups, aryl groups, saturated or unsaturated cyclic alkyl groups, saturated or unsaturated cyclic aralkyl groups, and saturated or unsaturated cyclic alkylaryl groups;
R2 represents at least one selected from saturated or unsaturated fluoro-substituted alkyl groups, saturated or unsaturated fluoro-substituted aralkyl groups, saturated or unsaturated fluoro-substituted alkylaryl groups, fluoro-substituted aryl groups, saturated or unsaturated fluoro-substituted cyclic alkyl groups, saturated or unsaturated fluoro-substituted cyclic aralkyl groups, and saturated or unsaturated fluoro-substituted cyclic alkylaryl groups;
R3 is at least one selected from -COOH, -OH and -SH;
R4 is a moiety that undergoes a reaction under heat or light, and particularly includes at least one selected from epoxy group, methacrylate group, acrylate group, (meth)acryloyloxyalkyl group or 3-acryloyloxy-2-hydroxypropyl group; and
Each of a, b, c and d is a mole fraction excluding 0, wherein a + b + c + d is 1.

In another aspect, the present invention provides a super-hydrophobic photosensitive resin composition for forming barrier ribs for LCD pixels by optionally diluting 100 parts by weight of a photosensitive resin composition with 50-1,000 parts by weight of a solvent, and coating the photosensitive resin composition onto a glass substrate, followed by patterning and developing, wherein the photosensitive resin composition comprises:
(A) 100 parts by weight of a blended polymer of (A1) a first polymer with (A2) a second polymer, wherein the first polymer (A1) is prepared by polymerizing ingredients including (a11) 10-70 wt% of a radical reactive monomer having a C₄-C₃₀ cyclic or acyclic saturated or unsaturated alkyl, aryl, aralkyl or alkylaryl substituent, (a12) 3-40 wt% of at least one monomer selected from (meth)acrylic acid, vinyl alcohol and vinyl thiol, (a13) 5-40 wt% of (meth)acrylate end-capped with (meth)acryl group or 3-acryloyloxy-2-hydroxypropyl group, and (a14) 5-30 wt% of a radical reactive monomer having a fluoro-substituted C₄-C₃₀ cyclic or acyclic saturated or unsaturated alkyl, aryl, aralkyl or alkylaryl substituent, and the second polymer (A2) is prepared by polymerizing monomers including (a21) 10-70 wt% of a radical reactive monomer having a C₄-C₃₀ cyclic or acyclic saturated or unsaturated alkyl, aryl, aralkyl or alkylaryl substituent, (a22) 5-30 wt% of (meth)acrylic acid, and (a23) 5-40 wt% of (meth)acrylate end-capped with (meth)acryl group or 3-acryloyloxy-2-hydroxypropyl group;
(B) 50-120 parts by weight of a multi-functional (meth)acrylate monomer; and
(C) 1-20 parts by weight of a photo initiator.

Preferably, the first polymer and the second polymer are used in a weight ratio of 1: 0.01-12 (first polymer: second polymer) so as to realize desired super-hydrophobicity and basic physical properties required for barrier ribs.

A particular example of ingredient (A2) includes a polymer represented by the following Formula 2. Each unit forming the first polymer is preferably used in the above weight ratio. This is because when each unit forming the first polymer is used in an amount away from the above range, the material cannot realize sufficient hydrophobicity or may be readsorbed onto the resultant pattern after development. Particularly, when ingredient (a3) is used in an amount lower than the above range, the resultant polymer shows an excessively lowered crosslinking density, resulting in a problem related to a severe film thickness loss. On the other hand, when ingredient (a3) is used in an amount higher than the above range, it may cause storage stability or other problems including scum generation.

According to the present invention, it is preferable for the blended polymer to have a high alkali dissolution rate (ADR). However, the two polymers may have an adequate difference in dissolution rates. The dissolution rate may be replaced by an acid value (AV). It is important that the blended polymer has an AV of 20-1,000, and more preferably of 30-500. Although there is no particular limitation in the molecular weights of the first polymer and the second polymer, each polymer preferably has a number average molecular weight of 500-100,000, and more preferably of 1,000-50,000. 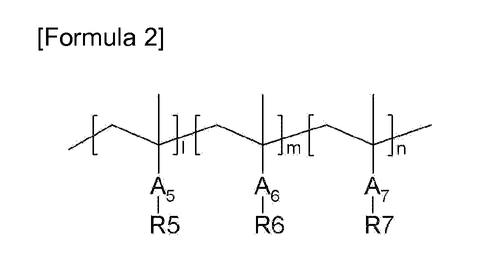
wherein A₅, A₆ and A₇ each represent -O-, -OCO-, -COO-, -S-, -CONH-, - NHCO-, or a covalent bond;
R5 independently represents at least one selected from C₄-C₃₀ saturated or unsaturated alkyl groups, saturated or unsaturated aralkyl groups, saturated or unsaturated alkylaryl groups, aryl groups, saturated or unsaturated cyclic alkyl groups, saturated or unsaturated cyclic aralkyl groups, and saturated or unsaturated cyclic alkylaryl groups;
R6 is at least one selected from -COOH, -OH and -SH;
R7 is a moiety that undergoes a reaction under heat or light, and particularly includes at least one selected from epoxy group, methacrylate group, acrylate group, (meth)acryloyloxyalkyl group or 3-acryloyloxy-2-hydroxypropyl group; and
Each of l, m and n is a mole fraction excluding 0, wherein l + m + n is 1.

In still another aspect, the present invention provides a super-hydrophobic photosensitive resin composition for forming barrier ribs for LCD pixels, which further comprises an adhesion promoter in addition to the photosensitive resin composition according to the first or the second aspect of the present invention, in an amount of 0.01-5 parts by weight based on 100 parts by weight of the first polymer. There is no particular limitation in the adhesion promoter, as long as the adhesion promoter is an alkoxysilane-based material. Particular examples of such materials include alkoxysilane compounds such as 3-vinyltrimethoxysilane, 3-vinyltriethoxysilane, trimethoxysilylbutyl methacrylate, etc. An epoxy or glycidyloxy structure represented by the following Formula 3 is preferred, because the use of such a glycidyloxy group-containing alkoxysilane realizes improved adhesion of the composition and barrier ribs obtained therefrom to a glass substrate. 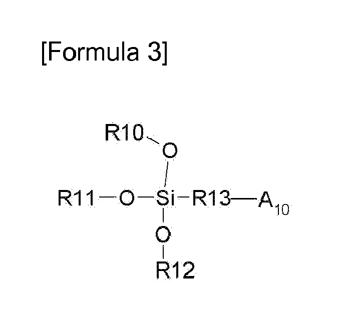
wherein A₁₀ is an epoxy group, (meth)acryl group, amino group, carboxyl group or hydroxyl group; each of R10-R12 is independently selected from methyl, ethyl, propyl and butyl; and R13 is a saturated or unsaturated hydrocarbyl group.

In yet another aspect, the present invention provides a super-hydrophobic photosensitive resin composition for forming barrier ribs for LCD pixels, which further comprises a UV quencher in addition to the photosensitive resin composition according to the first or the second aspect of the present invention. The photosensitive resin composition further comprising such a UV quencher realizes a mild curing rate upon photocuring, thereby improving the uniformity of a cured pattern on a glass substrate.

There is no particular limitation in the UV quencher, as long as the UV quencher is one used in photopolymerization, and particular examples thereof include a quinone compound such as hydroquinone, methylhydroquinone, anthraquinone, para-benzoquinone or *t*-butylhydroquinone, or TEMPO (tetramethylpiperidine-oxyl) compounds such as tetramethylpiperidine-1-oxyl, 4-hydroxy-tetramethylpiperidine-1-oxyl, 4-amino-tetramethylpiperidine-1-oxyl or 4-oxo-tetramethylpiperidine-1-oxyl. The quenching agent is used in an amount of 0.1-20 parts by weight based on 100 parts by weight of the first polymer (when only the first polymer is used) or the blended polymer (when both the first polymer and the second polymer are used) to prevent excessive lowering of the reaction rate and to improve the surface uniformity by inhibiting severe photocuring. Although there is no particular limitation in the photoinitiator that may be used in the present invention, it is preferred that the photoinitiator is easily dissolved in the composition according to the present invention. The photoinitiator is used in an amount of 0.1-20 parts by weight based on 100 parts by weight of the first polymer (when only the first polymer is used) or the blended polymer (when both the first polymer and the second polymer are used).

As the initiator, photoinitiators for ghi-line exposure may be used with no particular limitation. Particular examples of the photoinitiator that may be used in the present invention include alpha-hydroketones, alpha-hydroacetophenones, alpha-aminoketones, alpha-aminoacetophenones, benzyl dimethyl ketals, phosphine oxides, trichlorotriazines, and oxime esters. Oxime esters are preferred in view of the sensitivity (photoreactivity), reaction rate and solubility in the solvent used in the composition according to the present invention.

There is no particular limitation in the solvent used in the composition according to the present invention, as long as the solvent can dissolve the ingredients forming the composition. However, ester solvents are preferred in view of the solubility. Particular examples of the solvent that may be used in the present invention include methylmethoxypropionate (MMP), ethyl lactate (EL), methyl ethyl ketone (MEK), cyclohexanone (CHON), ethyl cellosolve (EC), butyl cellosolve (BC), propyl cellosolve (PrC), propylene glycol methyl ether acetate (PGMEA), propylene glycol monomethyl ether (PGME), dipropylene glycol dimethyl ether (DPGDME), or the like.

The multi-functional (meth)acrylate monomer that may be used in the present invention includes a monomer having at least two (meth)acrylate groups. The multi-functional (meth)acrylate monomer may be selected considering the desired strength or physical properties of barrier ribs to be produced from the composition according to the present invention. Particular examples of the multi-functional (meth)acrylate monomer include dipentaerythritol hexaacrylate (DPHA), pentaerythritol tetraacrylate (PETA), trimethylolpropane triacrylate (TMPTA), ethoxylated trimethylolpropane triacrylate (TMPEOTA), hexanediol diacrylate (HDDA), ethoxylated hexanediol diacrylate (HDEODA), 2-hydroxypropyl diacrylate (2-HPA), isobornyl diacrylate, polyethylene glycol diacrylate(PEGDA), and polymeric multi-functional (meth)acrylates such as polyurethane diacrylate, polyurethane triacrylate, polyurethane tetraacrylate, polyether diacrylate or polyester diacrylate having a molecular weight of 200-10,000. Such monomers may be used alone or in combination.

In addition, the photosensitive resin composition according to the present invention further comprises conventional additives including a defoaming agent, viscosity modifier, flame retardant, etc., as necessary. The amount of such additives is determined in such a manner that the presence of the additives does not adversely affect the super-hydrophobicity or developability of the composition according to the present invention.

Hereinafter, a process for forming barrier ribs for LCD pixels according to the present invention will be explained.

The process for forming barrier ribs in an LCD by using the photosensitive resin composition according to the present invention is based on UV curing and thermal curing of the photosensitive resin selected for each aspect of the present invention in order to realize super-hydrophobicity.

The polymer chain forming the photosensitive resin according to the present invention undergoes surface reconstruction to minimize its surface energy depending on the circumstance conditions. In other words, a part with relatively higher hydrophobicity tends to move towards a surface when the surface is in contact with the air, while a part with relatively higher hydrophilicity tends to hide into the binder. The basic concept of the present invention is in fixing and maximizing such a fundamental surface reconstruction phenomenon.

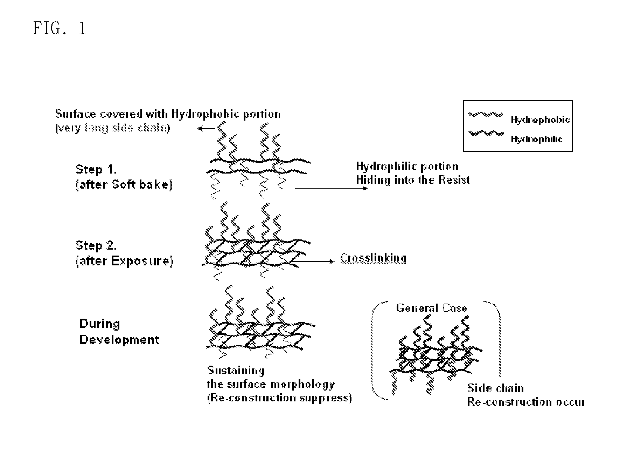

According to the present invention, a side chain containing a hydrophobic group such as a long-chain alkyl group or fluoro-substituted alkyl group introduced thereto has at least four carbon atoms so that the chain can move easily (step 1, FIG. 1), thereby maximizing surface reconstruction of the hydrophobic part. Then, the hydrophobic side chain preliminarily protruding out from the backbone by such a sufficient length is subjected to UV curing and is fixed on the surface in order to prevent reversion of the side chain during the subsequent development step essentially required for patterning.

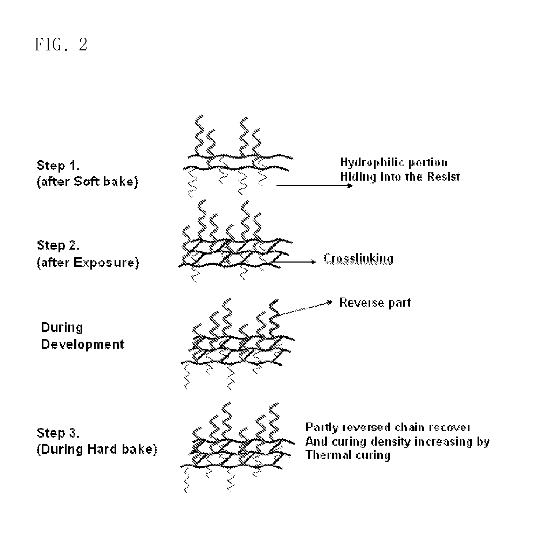

Herein, the curing degree is in proportion to the number of reactive sites. Therefore, the multi-functional monomer is used for such fixing to accomplish the curing to the highest density (step 2, FIG. 1). Finally, the polymer is further subjected to curing during a hard bake step after the development step, depending on the kinds of functional groups substituted on the polymer chain, so as to recover a partial surface structure that might have been reversed in the preceding steps, and to reinforce the curing (step 3, FIG. 2).

As can be seen from the foregoing, the present invention provides a transparent negative photosensitive super-hydrophobic material for ink jet printing, which has super-hydrophobicity characterized by a contact angle value of > 90° to distilled water and a contact angle value of > 35° to ethyl cellosolve, is sufficiently dissolved in a developing agent before and after exposure, and can realize a micropattern with a size up to 15 µm, preferably up to 10 µm. The super-hydrophobic barrier ribs for LCD pixels obtained by using the super-hydrophobic photosensitive resin composition according to the present invention realize sufficient adhesion and high wetting ability of inks when an ink jet printing step is performed by using RGB (red, green and blue) inks (i.e., when the RGB inks are sprayed or dropped into developed cells by way of ink jet printing) after the formation of the barrier ribs for LCD pixels. Additionally, the barrier ribs (i.e. pattern for forming the pixels) formed from the composition ensure such an extreme degree of hydrophobicity that the inks maintain their droplets in one cell without overflowing toward another cell in spite of an excessive dropping amount. As a result, the present invention can simplify the overall process for fabricating an LCD while minimizing defects during the fabrication.

### EXAMPLES

The following examples illustrate the invention and are not intended to limit the same.

### Example 1

The following ingredients were mixed:
73.20 g (solid content 15.8 wt%) of a first polymer (weight average molecular weight 15,000) containing octyl methacrylate, methacrylic acid, perfluorohexyl methacrylate and 3-acryloyloxy-2-hydroxypropyl methacrylate units in a molar ratio of 1:0.5:0.5:0.5;
3.14 g (solid content 36.9 wt%) of a second polymer (weight average molecular weight 22,000) containing octyl methacrylate, methacrylic acid and 3-acryloyloxy-2-hydroxypropyl methacrylate units in a molar ratio of 1:0.5:0.5;
10.98 g of dipentaerythritol hexaacrylate;
1.73 g of polyurethane diacrylate having a number average molecular weight of 3000 (Kayarad UXE3024 available from Nippon Kayaku Co.);
4.0 g of an oxime ester initiator (Irgacure 369 available from Ciba Geigy Corp.);
0.5 g of 3-glycidoxypropyl trimethoxysilane;
0.5 g of a coating improver (EFKA 2035 available from Ciba Geigy Corp.); and
48 g of propylene glycol methyl ether acetate.

The resultant mixture was violently agitated for three hours to provide a super-hydrophobic photosensitive resin solution, which, in turn, was coated onto a glass substrate with a size of 10 mm X 10 mm by using an SUSS Microtec GAMMA instrument. The photosensitive resin solution is coated onto the glass substrate in an amount of 4 cc per unit area of the glass substrate. Next, a resist layer was spin coated to a coating thickness of 38000±500 Å, and a soft bake step was carried out at 105°C for 90 seconds, followed by cooling, to provide a glass substrate.

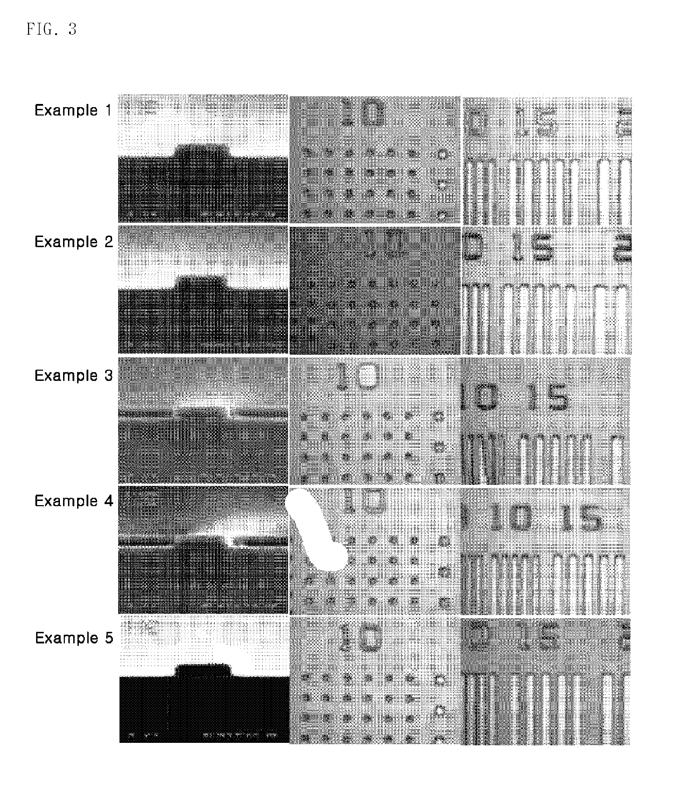

The glass substrate was coated with a photoresist layer by using a pattern mask and was introduced into an SUSS Microtec MA-6 ghi-line exposure system to perform an exposure step under a dose of 22.0 mW (365 nm, I-line wavelength) with a proximity gap of 50 µm. Next, the glass substrate was subjected to swing under 50 rpm while it was dipped in 0.4 wt% TMAH (teteramethylammonium hydroxide) developer at 25±0.5°C for 150 seconds, was rinsed with distilled water, and dewatered by using an air gun. Then, the glass substrate was further subjected to thermal curing in a convection oven at 220°C for 60 minutes. The profile of the resultant pattern was monitored and each contact angle value to ethyl cellosolve and water (H₂O) was determined. The results are shown in FIG. 3 and Table 1.

### Example 2

Example 1 was repeated except that the weight ratio of the first polymer : the second polymer (weight average molecular weight 15,000) was 1:1 on the solid content basis. The results are shown in FIG. 3 and Table 1.

### Example 3

Example 1 was repeated except that the weight ratio of the first polymer : the second polymer (weight average molecular weight 10,000) was 1:2 on the solid content basis, and FZ1225 (Dow Corning Toray Co.) was used as a coating improver. The results are shown in FIG. 3 and Table 1.

### Example 4

Example 1 was repeated except that the weight ratio of the first polymer (weight average molecular weight 25,000) : the second polymer (weight average molecular weight 10,000) was 1:9 on the weight basis, and 1.0 g of 4-hydroxy-TEMPO (Tokyo Kasei Kogyo) was further added as a UV quencher. The results are shown in FIG. 3 and Table 1.

### Example 5

Example 3 was repeated except that polyurethane diacrylate was not used, dipentaerythritol hexaacrylate was used in the same amount as the solid content of the first polymer and the second polymer, and the oxime ester initiator was changed and reduced from 4.0 g of Irgacure 369 to 1.0 g of Irgacure OXE-02 (Ciba Geigy Corp.). The results are shown in FIG. 3 and Table 1.

### Example 6

Example 1 was repeated except that the oxime ester initiator was changed and reduced from 4.0 g of Irgacure 369 to 2.0 g of Irgacure OXE-01 (Ciba Geigy Corp.).

### Example 7

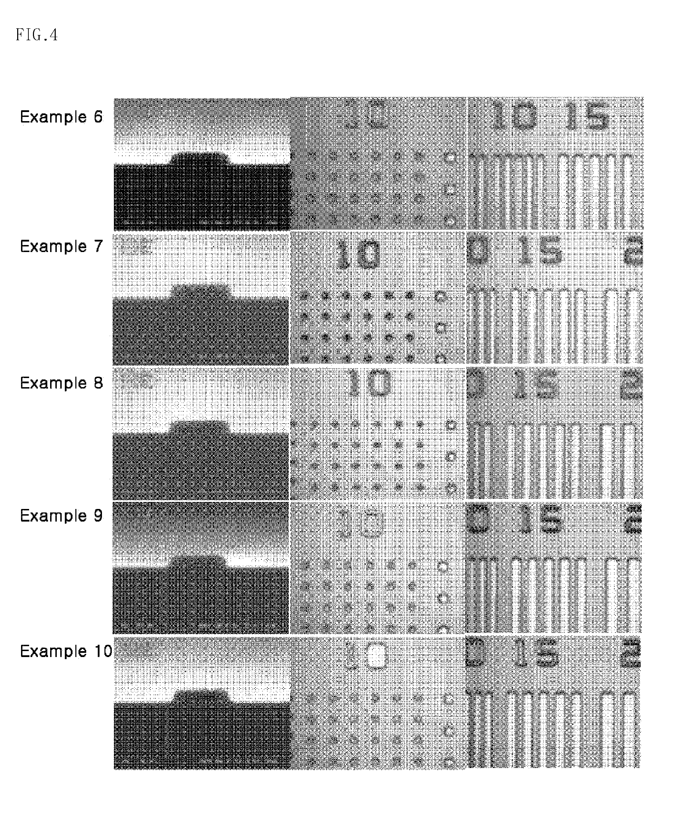

Example 5 was repeated except that dipentaerythritol hexaacrylate was used in an amount corresponding to 80% of the original amount, 2 parts by weight of polyurethane diacrylate was used based on 100 parts by weight of dipentaerythritol hexaacrylate, and 0.3 g of 4-hydroxy-TEMPO (Tokyo Kasei Kogyo) was further added as a UV quencher. The results are shown in FIG. 4 and Table 1.

### Example 8

Example 2 was repeated except that dipentaerythritol hexaacrylate and polyurethane diacrylate were used in a weight ratio of 1:1 but in the same combined weight. The results are shown in FIG. 4 and Table 1.

### Example 9

Example 5 was repeated except that dipentaerythritol hexaacrylate was used in an amount corresponding to 50% of the original amount and the balance amount of pentaerythritol tetraacrylate (NK ESTER CBX-1 N, Shinnakamura Co.) was used. The results are shown in FIG. 4 and Table 1.

### Example 10

Example 8 was repeated except that methoxymethyl propionate was used instead of propylene glycol methyl ether acetate as the solvent. The results are shown in FIG. 4 and Table 1.

**[Table 1] Contact Angle Values of Examples and Blanks**

| Examples | Patterning ability | | Contact angle value | | | |
|---|---|---|---|---|---|---|
| | L/S (15 µm) | C/H (10 µm) | Pattern | | Blank | |
| | Spec: 16-18 | Open | EC | DIW | EC | DIW |
| 1 | 17.30 | O.K. | 64.2 | 121.6 | < 5 | 59.8 |
| 2 | 16.98 | O.K. | 52.8 | 101.1 | < 5 | 60.3 |
| 3 | 17.11 | O.K. | 53.5 | 102.0 | < 5 | 64.7 |
| 4 | 16.33 | O.K. | 49.0 | 100.5 | < 5 | 66.1 |
| 5 | 17.76 | O.K. | 46.2 | 100.6 | < 5 | 57.0 |
| 6 | 16.85 | O.K. | 64.5 | 122.1 | < 5 | 60.8 |
| 7 | 17.51 | O.K. | 55.3 | 103.8 | < 5 | 57.2 |
| 8 | 17.58 | O.K. | 49.5 | 105.4 | < 5 | 65.5 |
| 9 | 16.77 | O.K. | 51.0 | 105.3 | < 5 | 66.1 |
| 10 | 16.79 | O.K. | 48.7 | 104.2 | < 5 | 64.0 |

The quality of the photoresist pattern according to each Example was evaluated by performing a lithographic test and measuring the contact angle value. In the lithographic test, a smaller pattern size of a mask used for exposure provides higher resolution. Also, the lithographic test determines whether such a small pattern size is accurately transferred onto a glass substrate without any change or not. As can be seen from the results in Table 1, in the case of 15 µm line-and-space (L/S) mask patterns, the patterns are formed normally in a range of 16-18 µm, which is generally acceptable in the current LCD fabrication processes. Also, relatively small size patterns, i.e., 10.0 µm contact hole (C/H) patterns are opened in all cases, but not completely. When the holes are not opened in the patterns, metal interconnections for transferring electric signals cannot be made from the TFT. Therefore, such patterns cannot be used as a patterning material in a practical semiconductor or LCD fabrication process. The above two lithographic test results determine whether a high-sensitivity developable negative photoresist is formed or not. In addition, measurement of contact angle values determines whether the photoresist ensures sufficient hydrophobicity and hydrophilicity or not. In the above test, each of the photosensitive resin compositions according to Examples 1-10 showed a contact angle value of at least 45° on the pattern forming the outer walls of pixels, as measured in ethyl cellosolve (at least 90° as measured in distilled water). This means that each photosensitive resin composition has super-hydrophobicity. On the contrary, in the inner part of the developed pixels, each photosensitive resin composition showed high hydrophilicity characterized by a contact angle value of about 59°-66°, as measured in distilled water (DIW)(<10° as measured in ethyl cellosolve). It can be seen from the above results that the photosensitive resin composition according to the present invention realizes excellent wettability of RGB inks in the inner part of LCD pixels due to such high hydrophilicity, when an ink jet printing step is carried out by spraying or dropping the RGB inks into the LCD pixels, while the super-hydrophobic barrier ribs formed from the composition completely separate the pixels to prevent the inks from overflowing even though the ink loading amount increases.

### Comparative Example 1

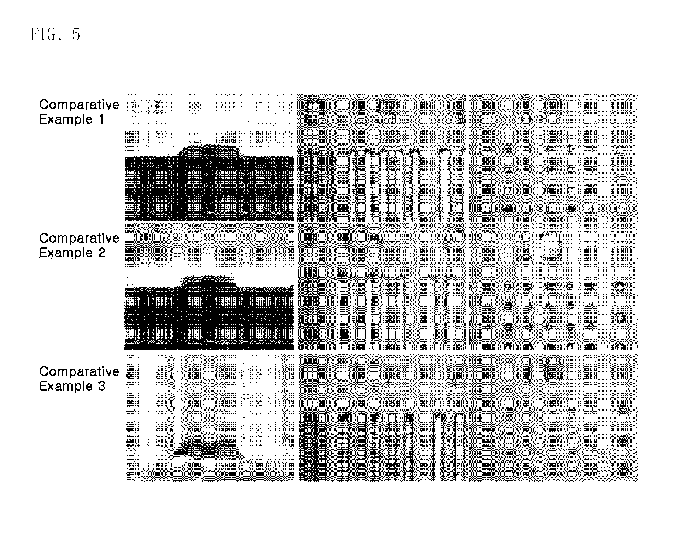

Example 1 was repeated except that the first polymer was not used and the same amount of the second polymer substituted for the first polymer to provide a resin solution. The results are shown in FIG. 5 and Table 2.

### Comparative Example 2

Example 1 was repeated except that the weight ratio of the first polymer (weight average molecular weight 25,000) : the second polymer (weight average molecular weight 10,000) was 1:15, and 1.0 g of TEMPO (Tokyo Kasei Kogyo) was further added as a UV quencher. The results are shown in FIG. 5 and Table 2.

### Comparative Example 3

Comparative Example 2 was repeated except that the first polymer having fluorine-containing groups was not used and another first polymer (weight average molecular weight 15,000) having the same proportion of C₁₈ linear alkyl groups instead of the fluorine-containing groups was used. The results are shown in FIG. 5 and Table 2.

**[Table 2] Contact Angle Values of Examples and Blanks**

| Comparative Examples | Patterning ability | | Contact angle value | | | |
|---|---|---|---|---|---|---|
| | L/S (15 µm) | C/H (10 µm) | Pattern | | Blank | |
| | Spec: 16-18 | Open | EC | DIW | EC | DIW |
| 1 | 18.09 | O.K. | 8.6 | 76.7 | < 5 | 63.3 |
| 2 | 17.75 | O.K. | 20.8 | 87.9 | < 5 | 56.7 |
| 3 | - | N.G. | 15.3 | 81.7 | < 5 | 83.8 |

As can be seen from the results of Table 2, in the case of 15 µm line-and-space (L/S) mask patterns, Comparative Examples 1 and 2 are within the acceptable range or show a slightly larger value. Additionally, 10.0 µm contact hole (C/H) patterns are opened in both Comparative Examples. This suggests that Comparative Examples 1 and 2 are not significantly different from the inventive Examples in terms of the lithographic test in spite of the use of a decreased amount of the first polymer or even the absence of the first polymer. However, Comparative Examples 1 and 2 cannot ensure the most important characteristic, i.e., super-hydrophobicitiy, and thus cannot be applied to an ink jet printing step even if they provide high-resolution photoresist. Additionally, in the case of Comparative Example 3 using a composition merely having a long linear alkyl chain, any significant difference in developability cannot be seen before and after development when the composition according to Comparative Example 3 is used as a photoresist layer. Thus, it is not possible to form a desired pattern and to realize desired super-hydrophobicity. Instead, the blank regions requiring hydrophilicity still show high hydrophobicity. This suggests that although a photosensitive resin composition having a modified composition is used to form a pattern as photoresist, it cannot be applied to an ink jet printing step, in principle. As can be seen from the all above results, photoresist that merely ensures good resolution cannot realize desired super-hydrophobicity, and the photosensitive resin composition free from the first polymer as defined herein cannot be applied to an ink jet printing step.

As can be seen from the foregoing, the present invention provides a super-hydrophobic photosensitive resin composition for forming barrier ribs in an LCD, which has both super-hydrophobicity and hydrophilicity. Therefore, the present invention can realize a simple LCD fabrication process, and can minimize consumption of color inks by preventing intermix of RGB inks even when RGB inks are sprayed(or dropped) simultaneously under an increased ink loading amount by virtue of the super-hydrophobicity of the barrier ribs formed from the composition. Additionally, the present invention can simplify the overall process for fabricating an LCD by avoiding a need for a photomask in a coloring step. Further, the super-hydrophobic photosensitive resin composition can be applied to a part requiring protection from water.

The invention has been described in detail with reference to preferred embodiments thereof. However, it will be appreciated by those skilled in the art that changes may be made in these embodiments without departing from the principles and spirit of the invention, the scope of which is defined in the accompanying claims and their equivalents.

## Claims

1. A super-hydrophobic photosensitive resin composition for forming barrier ribs for LCD pixels, including 100 parts by weight of a photosensitive resin composition and 50-1,000 parts by weight of a solvent, wherein the photosensitive resin composition comprises:
(A) 100 parts by weight of a first polymer prepared by polymerizing ingredients including (a1) 10-70 wt% of a radical reactive monomer having a C₄-C₃₀ cyclic or acyclic saturated or unsaturated alkyl, aryl, aralkyl or alkylaryl substituent, (a2) 3-40 wt% of at least one monomer selected from (meth)acrylic acid, vinyl alcohol and vinyl thiol, (a3) 5-40 wt% of (meth)acrylate end-capped with (meth)acryl group or 3-acryloyloxy-2-hydroxypropyl group, and (a4) 5-30 wt% of a radical reactive monomer having a fluoro-substituted C₄-C₃₀ cyclic or acyclic saturated or unsaturated alkyl, aryl, aralkyl or alkylaryl substituent;
(B) 50-120 parts by weight of a multi-functional (meth)acrylate monomer; and
(C) 1-20 parts by weight of a photo initiator.

2. A super-hydrophobic photosensitive resin composition for forming barrier ribs for LCD pixels, including 100 parts by weight of a photosensitive resin composition optionally with 50-1,000 parts by weight of a solvent, wherein the photosensitive resin composition comprises:
(A) 100 parts by weight of a blended polymer of (A1) a first polymer with (A2) a second polymer, wherein the weight ratio of the first polymer : the second polymer is 1:0.01-12, the first polymer (A1) is prepared by polymerizing ingredients including (a11) 10-70 wt% of a radical reactive monomer having a C₄-C₃₀ cyclic or acyclic saturated or unsaturated alkyl, aryl, aralkyl or alkylaryl substituent, (a12) 3-40 wt% of at least one monomer selected from (meth)acrylic acid, vinyl alcohol and vinyl thiol, (a13) 5-40 wt% of (meth)acrylate end-capped with (meth)acryl group or 3-acryloyloxy-2-hydroxypropyl group, and (a14) 5-30 wt% of a radical reactive monomer having a fluoro-substituted C₄-C₃₀ cyclic or acyclic saturated or unsaturated alkyl, aryl, aralkyl or alkylaryl substituent, and the second polymer (A2) is prepared by polymerizing monomers including (a21) 10-70 wt% of a radical reactive monomer having a C₄-C₃₀ cyclic or acyclic saturated or unsaturated alkyl, aryl, aralkyl or alkylaryl substituent, (a22) 5-30 wt% of (meth)acrylic acid, and (a23) 5-40 wt% of (meth)acrylate end-capped with (meth)acryl group or 3-acryloyloxy-2-hydroxypropyl group;
(B) 50-120 parts by weight of a multi-functional (meth)acrylate monomer; and
(C) 1-20 parts by weight of a photoinitiator.

3. A super-hydrophobic photosensitive resin composition for forming barrier ribs for LCD pixels as claimed in claim 1 or claim 2, wherein the photosensitive resin composition has a contact angle value of > 90° to distilled water and a contact angle value of > 35° to ethyl cellosolve.

4. A super-hydrophobic photosensitive resin composition for forming barrier ribs for LCD pixels as claimed in claim 3, wherein the first polymer and the second polymer are represented by the following Formula 1 and Formula 2, respectively: 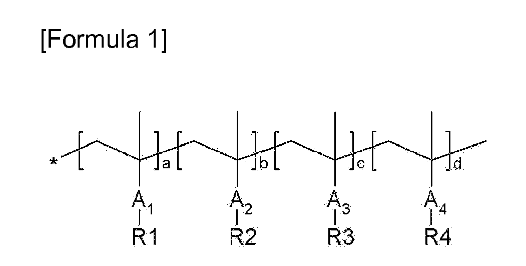
wherein A₁, A₂, A₃ and A₄ each represent -O-, -OCO-, -COO-, -S-, -CONH-, - NHCO-, or a covalent bond;
R1 independently represents at least one selected from C₄-C₃₀ saturated or unsaturated alkyl groups, saturated or unsaturated aralkyl groups, saturated or unsaturated alkylaryl groups, aryl groups, saturated or unsaturated cyclic alkyl groups, saturated or unsaturated cyclic aralkyl groups, and saturated or unsaturated cyclic alkylaryl groups;
R2 represents at least one selected from saturated or unsaturated fluoro-substituted alkyl groups, saturated or unsaturated fluoro-substituted aralkyl groups, saturated or unsaturated fluoro-substituted alkylaryl groups, fluoro-substituted aryl groups, saturated or unsaturated fluoro-substituted cyclic alkyl groups, saturated or unsaturated fluoro-substituted cyclic aralkyl groups, and saturated or unsaturated fluoro-substituted cyclic alkylaryl groups;
R3 is at least one selected from -COOH, -OH and -SH;
R4 is a moiety that undergoes a reaction under heat or light, and particularly includes at least one selected from epoxy group, methacrylate group, acrylate group, (meth)acryloyloxyalkyl group or 3-acaryloyloxy-2-hydroxypropyl group; and
Each of a, b, c and d is a mole fraction excluding 0, wherein a + b + c + d is 1; and 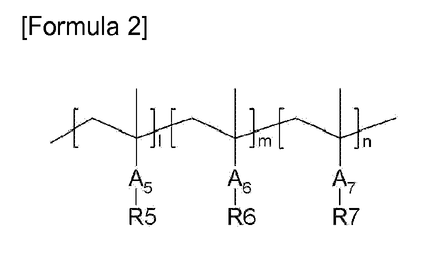
wherein A₅, A₆ and A₇ each represent -O-, -OCO-, -COO-, -S-, -CONH-, - NHCO-, or a covalent bond;
R5 independently represents at least one selected from C₄-C₃₀ saturated or unsaturated alkyl groups, saturated or unsaturated aralkyl groups, saturated or unsaturated alkylaryl groups, aryl groups, saturated or unsaturated cyclic alkyl groups, saturated or unsaturated cyclic aralkyl groups, and saturated or unsaturated cyclic alkylaryl groups;
R6 is at least one selected from -COOH, -OH and -SH;
R7 is a moiety that undergoes a reaction under heat or light, and particularly includes at least one selected from epoxy group, methacrylate group, acrylate group, (meth)acryloyloxyalkyl group or 3-acryloyloxy-2-hydroxypropyl group; and
Each of l, m and n is a mole fraction excluding 0, wherein l + m + n is 1.

5. A super-hydrophobic photosensitive resin composition for forming barrier ribs for LCD pixels as claimed in claim 3 or claim 4, which further comprises 0.01-5 parts by weight of an adhesion promoter based on 100 parts by weight of ingredient (A).

6. A super-hydrophobic photosensitive resin composition for forming barrier ribs for LCD pixels as claimed in claim 5, which further comprises 0.1-20 parts by weight of a quenching agent based on 100 parts by weight of ingredient (A).

7. A liquid crystal cell having barrier ribs formed from a super-hydrophobic photosensitive resin composition comprising the composition as defined in claim 1 or claim 2.

8. A liquid crystal display having the liquid crystal cell as defined in claim 7.
